# EUROPEAN PATENT APPLICATION

(11) **EP 4 719 011 A1**
(43) Date of publication of application: **01.04.2026**
(21) Application number: 24813753.1
(22) Date of filing: 22.02.2024
(51) Int. Cl.: H10K 30/81

(54) **COMPOSITE ELECTRODE, SOLAR CELL AND MANUFACTURING METHOD THEREFOR, AND ELECTRIC AND ENERGY STORAGE DEVICE**

(30) Priority: 29.05.2023 CN 202310618013
(71) Applicant: Contemporary Amperex Technology Co., Limited, Ningde, Fujian 352100 (CN)
(72) Inventor: TU, Bao, Ningde, Fujian 352100 (CN); CHEN, Guodong, Ningde, Fujian 352100 (CN); SU, Shuojian, Ningde, Fujian 352100 (CN); LIU, Xiao, Ningde, Fujian 352100 (CN); GUO, Wenming, Ningde, Fujian 352100 (CN); GUO, Yongsheng, Ningde, Fujian 352100 (CN)
(74) Representative: Gong, Jinping
(86) International application number: PCT/CN2024/078022
(87) International publication number: WO 2024/244547

(57) **Abstract**

The present application discloses a composite electrode, a solar cell, methods for preparing the same, a power consuming apparatus, and an energy storage apparatus. The composite electrode includes a conductive oxide substrate and a metal doped in the conductive oxide substrate. The composite electrode has good stability performance, and also functions as a matrix to protect the doped metal, thereby improving chemical stability of the metal. The doped metal modifies the conductive oxide substrate, thereby significantly improving electrical conductivity of the composite electrode. A back electrode of the solar cell includes the composite electrode. The photoelectric performance of the solar cell is enhanced and remains stable.

## Description

The present application claims priority to Chinese Patent Application No. 202310618013.4, filed with the China National Intellectual Property Administration on May 29, 2023 and entitled "COMPOSITE ELECTRODE, SOLAR CELL, METHODS FOR PREPARING SAME, POWER CONSUMING APPARATUS, AND ENERGY STORAGE APPARATUS", which is incorporated herein by reference in its entirety.

### TECHNICAL FIELD

The present application belongs to the technical field of perovskite solar cells, and specifically relates to a composite electrode and a method for preparing the same, a solar cell and a method for preparing the same, a power consuming apparatus, and an energy storage apparatus.

### BACKGROUND

Perovskite solar cells (PSCs) are mainly composed of five parts: transparent conducting oxide, an electron transport layer, a perovskite light-absorbing layer, a hole transport layer, and a metal back electrode. The perovskite light-absorbing layer uses perovskite-type organometallic halides (referred to as perovskite materials) as a light-absorbing material. Under irradiation, the perovskite material can generate photogenerated carriers.

Currently, back electrode materials in perovskite solar cells are generally metallic materials, which are prone to oxidation, leading to a decrease in the photoelectric conversion efficiency of the perovskite solar cells. Further, the poor light transmittance of the metal back electrode restricts the application of the perovskite solar cells.

### TECHNICAL PROBLEM

In view of the foregoing problems, embodiments of the present application provide a composite electrode, a solar cell, methods for preparing the same, a power consuming apparatus, and an energy storage apparatus, to solve the technical problem of the reduced photoelectric conversion efficiency of the perovskite solar cells caused by the easy oxidation of the metal back electrode.

### TECHNICAL SOLUTIONS

In a first aspect, an embodiment of the present application provides a composite electrode. In this embodiment of the present application, the composite electrode includes a conductive oxide substrate and further includes a metal. The metal is doped in the conductive oxide substrate.

In this embodiment of the present application, the conductive oxide substrate contained in the composite electrode endows the composite electrode with good stability performance, meanwhile, protects the doped metal, and reduces the probability of metal oxidation, thereby enhancing the operational stability of the composite electrode. When the composite electrode is used in an electrode in a perovskite solar cell, the stability of the operational performance of the perovskite solar cell can be effectively improved, such as improving the stability of the photoelectric conversion efficiency.

In some embodiments, the volume percentage content of the metal doped in the composite electrode is less than or equal to 8%, optionally 0.5% to 5%. By controlling and adjusting the doping amount of the metal in the composite electrode, the operational stability and photoelectric conversion stability of the composite electrode are improved.

In some embodiments, the metal includes at least one metal from a Group IIIA element, a Group IB element, and a Group IIB element. The Group IIIA element includes at least one of aluminum, gallium, indium, and thallium. The Group IB element includes at least one of copper, gold, and silver. The Group IIB element includes at least one of zinc and cadmium.

After doping the conductive oxide substrate with the aforementioned metals, the chemical stability and conductivity of the composite electrode can be further enhanced. Moreover, some metals also exhibit a certain degree of light transmittance, thereby improving the light transmittance of the composite electrode.

In some embodiments, in a thickness direction of the composite electrode, the metal is in a gradient distribution within the composite electrode.

When the doped metal is controlled to be in the gradient distribution and is used as a back electrode of the perovskite solar cell, a surface with a low metal doping amount exhibits higher chemical stability, while a surface with a high metal doping amount demonstrates better conductivity, thereby further improving both the chemical stability and conductivity of the composite electrode, and enhancing the photoelectric performance and the stability of the photoelectric performance of the perovskite solar cell.

In an embodiment, the composite electrode includes a first metal-doped layer, a second metal-doped layer, and a third metal-doped layer, which are sequentially arranged in the thickness direction of the composite electrode.

In an embodiment, the volume percentage content of the metal in the first metal-doped layer is 0%, the volume percentage content of the metal in the second metal-doped layer is 0.1% to 2%, and the volume percentage content of the metal in the third metal-doped layer is 2% to 8%.

In an embodiment, a thickness ratio of the first metal-doped layer to the second metal-doped layer to the third metal-doped layer is 1: (1-3): (1-5).

By controlling the formation of the gradient distribution of the metal within the composite electrode that includes the three metal-doped layers, and further controlling the thickness and the metal doping content of each metal-doped layer, the metal is allowed to exert the aforementioned functions, and therefore the composite electrode has excellent chemical stability and electrical conductivity.

In some embodiments, the conductive oxide substrate includes a light-transmitting metal oxide. By using the metal oxide as the conductive oxide substrate, the composite electrode according to this embodiment of the present application has both the excellent chemical stability and conductivity.

In an embodiment, a metal element contained in the metal oxide includes at least one of a Group IIIA element, a Group IVA element, a Group IB element, and a Group IIB element. The Group IIIA element includes at least one of aluminum, gallium, indium, and thallium. In an exemplary example, the Group IVA element includes tin, the Group IB element includes at least one of copper, gold, and silver, and the Group IIB element includes at least one of zinc and cadmium.

The types of the above conductive oxide substrates simultaneously exhibit excellent chemical stability and conductivity, while also possessing good light transmittance. Therefore, the composite electrode according to this embodiment of the present application simultaneously has the excellent chemical stability, conductivity, and light transmittance.

In an exemplary example, the metal includes aluminum, gallium, indium, and thallium, and the conductive oxide includes tin oxide. The composite electrode containing the tin oxide substrate and the four doped metals: aluminum, gallium, indium, and thallium simultaneously have more excellent chemical stability, conductivity, and light transmittance.

In some embodiments, the composite electrode includes at least one of the following (1) to (3):
(1) a thickness ranging from 60 nm to 200 nm, optionally 80 nm to 100 nm;
(2) a work function value ranging from 4 eV to 5.5 eV, optionally 4.26 eV to 5.20 eV; and
(3) a square resistance ranging from 5 Ω to 15 Ω, optionally 7 Ω to 11 Ω.

When the composite electrode according to this embodiment of the present application has at least one of the foregoing characteristics (1) to (3), the applicability of the composite electrode according to this embodiment of the present application in the perovskite solar cell is enhanced.

In a second aspect, an embodiment of the present application further provides a method for preparing a composite electrode. The method for preparing a composite electrode according to the present application includes the following step:
performing film formation processing on a surface of a matrix using raw materials containing a metal and a conductive oxide to form the composite electrode.

The method for preparing a composite electrode according to this embodiment of the present application can effectively achieve doping of the conductive oxide substrate with the metal, and endow the prepared composite electrode with excellent chemical and conductive properties.

In some embodiments, a method for performing film formation on a surface of a matrix using raw materials containing a metal and a conductive oxide includes at least one of magnetron sputtering, a co-evaporation method, an atomic layer deposition method, and an ion plating method.

In a third aspect, an embodiment of the present application further provides a solar cell. The solar cell according to this embodiment of the present application includes a transparent electrode and a back electrode which are oppositely arranged. A first transport layer, a perovskite light-absorbing layer, and a second transport layer which are sequentially stacked in a direction from the transparent electrode to the back electrode are further arranged between the transparent electrode and the back electrode.

The back electrode includes the composite electrode according to this embodiment of the present application or the composite electrode prepared by the method for preparing a composite electrode according to this embodiment of the present application.

The back electrode in the solar cell according to this embodiment of the present application has good chemical stability, good stability of the operational performance, and excellent electrical conductivity, thereby improving the photoelectric performance and stability of the photoelectric performance of the perovskite solar cell.

In some embodiments, in a thickness direction of the composite electrode, the metal contained in the composite electrode is in a gradient distribution within the composite electrode, and one side of the composite electrode with a low metal content is stacked towards the second transport layer. A surface of one side of the back electrode with a low metal doping amount is arranged towards the second transport layer, thereby effectively collecting excitons transmitted from the transport layer, and further enhancing the photoelectric performance and the stability of the photoelectric performance of the perovskite solar cell.

In some embodiments, the second transport layer is a hole transport layer or an electron transport layer.

In an embodiment, a hole transport material contained in the hole transport layer includes at least one of a material denoted as M, a derivative of the material denoted as M, a doped and modified material of the material denoted as M, and a passivated material of the material denoted as M.

The M includes at least one of: poly[bis(4-phenyl)(2,4,6-trimethylphenyl)amine], poly-3-hexylthiophene, triphenylamine with a triptycene core, 3,4-ethylenedioxythiophene-methoxytriphenylamine, N-(4-anilinophenyl)carbazole-spirobifluorene, poly(3,4-ethylenedioxythiophene):poly(styrenesulfonate), polythiophene, nickel oxide, molybdenum oxide, copper iodide, and cuprous oxide.

In an embodiment, a thickness of the hole transport layer is 0.1 nm to 30 nm.

In an embodiment, an electron transport material contained in the electron transport layer includes at least one of a material denoted as N, a derivative of the material denoted as N, a doped and modified material of the material denoted as N, and a passivated material of the material denoted as N.

The N includes at least one of methyl [6,6]-phenyl-C61-butyrate, methyl [6,6]-phenyl-C71-butyrate, fullerene C60, fullerene C70, tin dioxide, and zinc oxide.

In an embodiment, a thickness of the electron transport layer is 10 nm to 80 nm.

The above hole transport layer and electron transport layer thicknesses and transport materials facilitate well collecting and transporting of excitons generated by the photoexcitation of the perovskite light-absorbing layer. When the hole transport layer and the electron transport layer serve as the second transport layers, these transport materials may be adjusted to be relatively matched with energy levels of the above back electrode.

In some embodiments, quantum dots are further doped in the perovskite light-absorbing layer. By doping the quantum dots into the perovskite light-absorbing layer, a spectral range of sunlight absorbed by the perovskite light-absorbing layer can be broadened, and the light absorption capability of the perovskite light-absorbing layer can be improved, thereby improving the photoelectric conversion efficiency of the solar cell.

In some embodiments, a thickness of the perovskite light-absorbing layer is 400 nm to 1000 nm. The thickness range can further improve the light absorption capability of the perovskite light-absorbing layer, thereby improving the photoelectric conversion efficiency of the solar cell and the stability of the photoelectric conversion efficiency.

In a fourth aspect, an embodiment of the present application further provides a method for preparing a solar cell. The method for preparing a solar cell according to this embodiment of the present application includes the following steps:
in a direction away from a surface of a transparent electrode, sequentially forming a first transport layer, a perovskite light-absorbing layer, and a second transport layer which are stacked on the surface of the transparent electrode; and
performing, according to the method for preparing a composite electrode according to the above embodiment of the present application, film formation processing on a surface of the second transport layer away from the perovskite light-absorbing layer, to form the composite electrode.

The back electrode contained in the solar cell prepared by the method for preparing a solar cell according to this embodiment of the present application has high stability and electrical conductivity as described above, or further has good light transmittance, such as translucency.

In some embodiments, the perovskite light-absorbing layer contains quantum dots, and a method for forming the perovskite light-absorbing layer includes the following steps:
preparing a mixed solution using the quantum dots and perovskite precursors;
performing first film formation processing on the surface of the first transport layer away from the transparent electrode using the mixed solution to form a perovskite precursor film layer; and
performing annealing treatment on the perovskite precursor film layer to obtain the perovskite light-absorbing layer.

By preparing the perovskite light-absorbing layer in one step using the mixed solution formed by the quantum dots and the perovskite precursors, the defects in the perovskite light-absorbing layer as well as the light absorption capability and the photoexcited exciton separation capability can be effectively reduced.

In a fifth aspect, an embodiment of the present application further provides a power consuming apparatus. The power consuming apparatus according to this embodiment of the present application includes a power supply unit or an energy storage unit. The power supply unit or the energy storage unit contains a solar cell. The solar cell the solar cell according to the embodiment of the present application or the solar cell prepared by the method for preparing a solar cell according to the embodiment of the present application. The power consuming apparatus according to this embodiment of the present application can effectively convert the sunlight into electrical energy with relatively high efficiency, and improve the operational stability of the power supply unit or the energy storage unit.

In a sixth aspect, an embodiment of the present application further provides an energy storage apparatus. The energy storage apparatus according to this embodiment of the present application includes an energy storage unit. The energy storage unit includes a solar cell. The solar cell includes the solar cell according to the embodiment of the present application or the solar cell prepared by the method for preparing a solar cell according to the embodiment of the present application. The energy storage apparatus according to this embodiment of the present application can effectively convert the sunlight into electrical energy with relatively high efficiency, and the conversion efficiency is stable for storage.

The above description only refers to an overview of the technical solution of the present application. In order to understand the technical means of the present application more clearly, it may be implemented according to the content of the specification. In order to make the above-mentioned and other obj ectives, features and advantages of the present application more apparent, the specific implementations of the present application are listed below.

### BRIEF DESCRIPTION OF THE DRAWINGS

Various other advantages and benefits will become apparent to those of ordinary skill in the art upon reading the following detailed description of the optional implementations. The accompanying drawings are merely used for illustrating the optional implementations but are not to be considered as limitations to the present application. In addition, in all the accompanying drawings, the same components are indicated by the same reference numerals. In the accompanying drawings:
FIG. 1 illustrates a schematic diagram of some structures of a composite electrode according to an embodiment of the present application;
FIG. 2 illustrates a schematic diagram of some other structures of a composite electrode according to an embodiment of the present application;
FIG. 3 illustrates a schematic structural diagram of a gradient distribution of metals in three-layer metal doping in a composite electrode according to an embodiment of the present application;
FIG. 4 illustrates a schematic diagram of some structures of a perovskite solar cell according to an embodiment of the present application; and
FIG. 5 illustrates a schematic diagram of some structures of a perovskite solar cell according to an embodiment of the present application, where a back electrode is the composite electrode shown in FIG. 3.

Reference numerals in the specific implementations are as follows:
5'-composite electrode, 51-conductive oxide matrix, 52-metal, 53-first metal-doped layer, 54-second metal-doped layer, and 55-third metal-doped layer; and
1-transparent electrode, 2-first transport layer, 3-perovskite light-absorbing layer, 4-second transport layer, and 5-back electrode.

### DETAILED DESCRIPTION

The embodiments of the technical solutions of the present application will be described in detail below with reference to the accompanying drawings. The following embodiments are only used to illustrate the technical solutions of the present application more explicitly, and are thus only interpreted as examples, rather than used to limit the protection scope of the present application.

Unless otherwise defined, meanings of all technical and scientific terms used herein are the same as those usually understood by those skilled in the art to which the present application belongs. The terms used herein are merely intended to describe objectives of the specific embodiments, but are not intended to limit the present application. The terms "include" and "have" and any variations thereof in the specification and the claims of the present application and in the description of the accompanying drawings above are intended to cover non-exclusive inclusion.

In the description according to the embodiments of the present application, the technical terms "first", "second", and the like are only used to distinguish different objects, and should not be understood as indicating or implying relative importance or implying the number, a specific order, or a primary and secondary relationship of indicated technical features. In the description according to the embodiments of the present application, "a plurality of" means two or more, unless otherwise expressly and specifically defined.

Reference to "embodiments" herein means that specific features, structures, or characteristics described in conjunction with the embodiments may be included in at least one embodiment of the present application. The appearances of the phrase in various places in the specification are not necessarily all referring to the same embodiment, nor a separate or alternative embodiment that is mutually exclusive of other embodiments. Those skilled in the art explicitly or implicitly understand that the embodiments described herein may be combined with other embodiments.

In the description of the embodiments of the present application, the term "and/or" is merely an association to describe associated objects, meaning that three relationships may exist, such as A and/or B, which may indicate three situations: A exists alone, both A and B exist, and B exists alone. In addition, the character "/" herein generally indicates an "or" relationship between the preceding and succeeding associated objects.

In the description of the embodiments of the present application, the term "a plurality of" means two or more (including two). Similarly, "a plurality of groups" means two or more groups (including two groups), and "a plurality of pieces" means two or more pieces (including two pieces).

In the description according to the embodiments of the present application, the directional or positional relationships indicated by the technical terms such as "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", and "circumferential", are only for the convenience of describing the embodiments of the present application and simplifying the description, rather than indicating or implying that the referred apparatus or component should have a specific orientation or should be configured and operated in the specific orientation, and therefore are not to be understood as limitations on the embodiments of the present application.

In the description of the embodiments of the present application, unless otherwise explicitly specified and defined, the technical terms such as "install", "connect", "connection", and "fix" should be understood in a broad sense. For example, the connection may be a fixed connection, a detachable connection, or an integral connection; or the connection may be a mechanical connection or an electrical connection; or the connection may be a direct connection, an indirect connection through an intermediate medium, internal communication between two components, or an interaction relationship between two components. For those of ordinary skill in the art, the specific meanings of the above terms in the embodiments of the present application may be interpreted according to specific situations.

Perovskite solar cells (PSCs) are mainly composed of five parts: transparent conducting oxide, an electron transport layer, a perovskite light-absorbing layer, a hole transport layer, and a metal back electrode. The perovskite light-absorbing layer uses perovskite-type organometallic halides (referred to as perovskite materials for short) as a light-absorbing material. When the energy of incident photons is greater than a band gap of the material, the perovskite light-absorbing layer absorbs the photons and gets excited to generate excitons, which are electron-hole pairs. Electrons and holes are transported through a transport layer and collected by a transparent electrode and the metal back electrode respectively.

Currently, the metal back electrode is typically made of a metallic material, which is susceptible to environmental influences such as adverse factors like moisture and oxygen, leading to oxidation reactions. As a result, the conductivity of the metal back electrode is reduced, thereby diminishing the capability to collect the electrons or the holes. Meanwhile, the current metal back electrode generally exhibits low light transmittance, such as being opaque. As application requirements increase, the metal back electrode liquid restricts the application of the perovskite solar cells.

To effectively improve the chemical stability of the back electrode, the present application, through research, has discovered that when conductive oxide is used as a substrate and doped with a specific type of metal, a formed composite electrode demonstrates high chemical stability and excellent conductivity. Based on that, the light transmittance of the composite electrode may also be further adjusted by selecting and controlling the oxide and the metal type, and the composite electrode is used as the back electrode of the perovskite solar cell to broaden the application range of the perovskite solar cell. Based on the research, the present application provides the following solutions.

### Composite electrode

In a first aspect, an embodiment of the present application provides a composite electrode. In this embodiment of the present application, the composite electrode includes a conductive oxide substrate and further includes a metal. The metal is doped in the conductive oxide substrate.

The conductive oxide substrate should be understood as a main component of the composite electrode in this embodiment of the present application, meaning that a conductive oxide is a main component, with the metal serving as a doping component. Doping should be understood as the metal being distributed within the conductive oxide substrate. The metal should be understood as a single-atom metal or metal particles.

By adopting the conductive oxide as the substrate, the composite electrode according to this embodiment of the present application exhibits good chemical stability, such as oxidation resistance. Meanwhile, the conductive oxide serves as a carrier for the metal, and the conductive oxide substrate isolates the metal from the environment, thereby protecting the doped metal, reducing the probability of metal oxidation, and thus enhancing the chemical stability of the metal and improving the operational stability of the composite electrode. When the conductive oxide substrate is used in an electrode in a perovskite solar cell, the stability of the operational performance of the perovskite solar cell can be effectively improved, such as improving the photoelectric conversion efficiency. Additionally, due to the doping of the metal, the metal modifies the conductive oxide substrate, thereby significantly improving the electrical conductivity of the conductive oxide.

Therefore, there is a synergistic effect between the conductive oxide record and the metal contained in the composite electrode according to this embodiment of the present application, endowing the composite electrode in the present application with high chemical stability and excellent electrical conductivity.

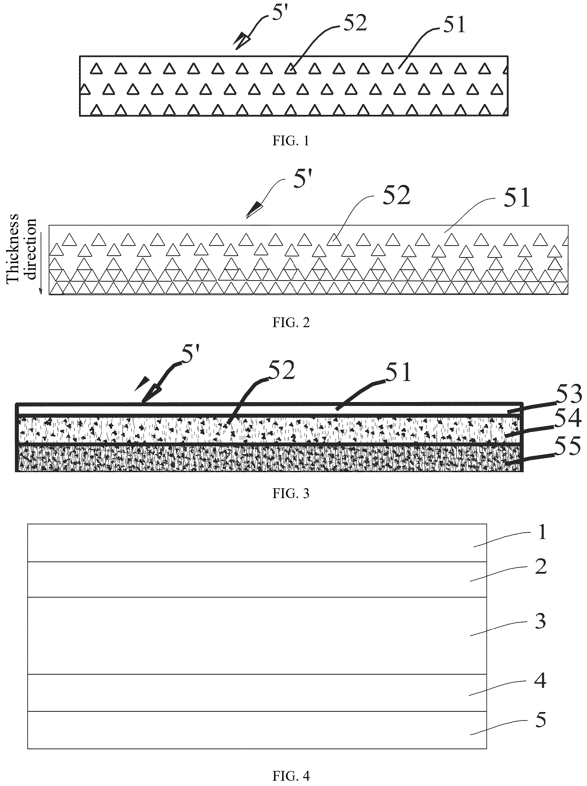

Based on a relationship between the conductive oxide substrate and the metal contained in the composite electrode according to this embodiment of the present application, the composite electrode according to this embodiment of the present application may have structures as shown in FIG. 1 and FIG. 2: the conductive oxide substrate forms a conductive oxide matrix 51 of a composite electrode 5' in this embodiment of the present application, with a metal 52 doped in the conductive oxide matrix 51.

The distribution of the metal 52 within the conductive oxide matrix 51 may be uniform, as shown in FIG. 1. By controlling the uniform doping of the metal 52, homogeneity of the composite electrode 5', including chemical stability and conductivity, can be enhanced.

Certainly, non-uniform doping is also possible. For example, in some embodiments, as shown in FIG. 2, in a thickness direction of the composite electrode 5', the metal 52 exhibits a gradient distribution within the composite electrode 5', namely the conductive oxide matrix 51.

The thickness direction refers to a direction perpendicular and a surface of the conductive oxide matrix 51. The gradient distribution may be understood in a way that in the thickness direction of the conductive oxide matrix 51, there are certain differences in the metal content concentration at different depths. For example, in a direction from one surface to the other surface of the conductive oxide matrix 51, which is a thickness direction as described in FIG. 2, the content of the metal 52 gradually increases or, certainly, may also gradually decrease.

By controlling the gradient doped distribution of the metal 52 in the thickness direction within the conductive oxide matrix 51, the doping amount of the metal 52 may be higher in one surface layer of the conductive oxide matrix 51 compared to the other opposite surface layer. When the metal is used in a back electrode of a perovskite solar cell, the surface with a low doping amount of the metal 52 exhibits higher chemical stability, while the surface with a high doping amount of the metal 52 demonstrates better conductivity, thereby further improving both the chemical stability and conductivity of the composite electrode 5', and enhancing the photoelectric performance and the stability of the photoelectric performance of the perovskite solar cell.

In this embodiment, when the metal 52 is in a gradient distribution within the conductive oxide matrix 51, the composite electrode 5' may contain a plurality of metal-doped layers, each with a different doping content of the metal 52. In the thickness direction of the composite electrode 5', namely, the direction from one surface towards the other opposite surface, the doping amount of the metal 52 in each metal-doped layer may increase or decrease in a gradient manner.

When the composite electrode 5' contains a plurality of metal-doped layers, as illustrated in an embodiment shown in FIG. 3, the composite electrode 5' includes a first metal-doped layer 53, a second metal-doped layer 54, and a third metal-doped layer 55, which are sequentially arranged in the thickness direction of the composite electrode 5'. It should be understood that the content of the metal 52 in the first metal-doped layer 53, the second metal-doped layer 54, and the third metal-doped layer 55 differs. For example, the doping amount of the metal 52 in the three metal-doped layers may increase sequentially or certainly decrease sequentially, forming the gradient distribution of the metal 52.

For example, in an embodiment, the volume percentage content of the metal 52 in the first metal-doped layer 53 is 0%. The volume percentage content of the metal 52 in the second metal-doped layer 54 ranges from 0.1% to 2%, specifically but not limited to a volume percentage range such as 0.1% to 1%, 1% to 1.5%, and 1.5% to 2%. The volume percentage content of the metal 52 in the third metal-doped layer 55 ranges from 2% to 8%, specifically but not limited to a volume percentage range such as 2% to 3%, 3% to 4%, 4% to 5%, 5% to 6%, 6% to 7%, and 7% to 8%.

In other embodiments, a thickness ratio of the first metal-doped layer 53 to the second metal-doped layer 54 to the third metal-doped layer 55 may be 1: (1-3): (1-5).

By controlling the gradient distribution of the metal 52 within the composite electrode 5', such as by forming the first metal-doped layer 53, the second metal-doped layer 54, and the third metal-doped layer 55 through controlling the doping amount of the metal 52, and arranging, in the thickness direction, these metal-doped layers in an ascending or descending order, the functions of the metal 52 as described above may be further enhanced, thereby allowing the composite electrode 5' to have excellent chemical stability and electrical conductivity.

In some embodiments, the metal 52 contained in the composite electrode of the foregoing embodiments may include at least one from a Group IIIA element, a Group IB element, and a Group IIB element.

In an embodiment, when the metal 52 is a Group IIIA element metal, the metal element includes at least one of aluminum, gallium, indium, and thallium. When the metal 52 is a Group IB element metal, the metal element includes at least one of copper, gold, and silver. When the metal 52 is a Group IIB element metal, the metal element includes at least one of zinc and cadmium.

The above types of metals 52 have good chemical stability and excellent conductivity. After doping the conductive oxide substrate, namely the conductive oxide matrix 51, the chemical stability and conductivity of the composite electrode can be further improved. Moreover, some metals also exhibit a certain degree of light transmittance, thereby improving the light transmittance of the composite electrode.

The metal 52 contained in the composite electrode according to the foregoing embodiments may be a single metal or two or more metals for combined doping. Regardless of whether it is a single metal or a combination of two or more metals 52 doping the conductive oxide matrix 51, the basis is to synergistically enhance the chemical stability and conductivity of the composite electrode in conjunction with the conductive oxide substrate. Additionally, the types of these metals 52 or a doping ratio of the combination of the two or more metals may also be certainly adjusted by further considering the economic cost and light transmittance of the composite electrode.

Based on the types of the above metals 52, in an embodiment, the metal 52 contained in the composite electrode according to the foregoing embodiments may include one or two or more of aluminum, gallium, indium, thallium, copper, gold, silver, zinc, cadmium, etc, where "two or more" includes a combination of two metals. When the metal 52 is a combination of two or more metals, the doping of the conductive oxide substrate, namely the conductive oxide matrix 51, by the metal 52 contained in the composite electrode according to the foregoing embodiments may include at least the following solutions:
In an embodiment, the metal 52 contained in the composite electrodes according to the foregoing embodiments may include, but is not limited to, combinations such as Au with Ag, Au with Al, or Au with In. In an embodiment, a volume ratio of the two metals, such as Au with Ag, Au with Al, and Au with In, may range from 0.1 to 0.9: 1.

In an embodiment, the metal contained in the composite electrode according to the foregoing embodiments may include, but is not limited to, combinations such as Au with Ag and Cd, Au with Al and Cu, Ga with In and Ti, or Ag with Ga and Zn.

In an exemplary example, the metal contained in the composite electrode according to the foregoing embodiments may include, but is not limited to, combinations such as Al, Ga, In, and Tl, or Ag, Zn, Cd, and Cu.

The types of the above metal 52, as well as the doping solutions involving a single metal or a combination of two or more metals, are merely examples of the above metal 52. When the metal 52 is composed of two or more metals for doping, the content of each metal may be adjusted as needed. Certainly, on the basis of ensuring the stability and conductivity of the composite electrode, other types of metals or combinations of two or more other metals may also be selected for doping by further considering factors such as the light transmittance and economic cost of the composite electrode.

In some embodiments, the volume percentage content of the metal 52 contained in the composite electrode according to the foregoing embodiments that is doped in the composite electrode is greater than 0 and less than or equal to 8%, optionally 0.5% to 5%. In an exemplary example, the doping volume of the metal may be typical but not exclusively limited to 0.5%, 1%, 1.5%, 2%, 2.5%, 3%, 3.5%, 4%, 4.5%, 5%, 5.5%, 6%, 6.5%, 7%, 7.5%, 8%, etc. By controlling and adjusting the doping amount of the metal in the composite electrode, the electrical conductivity of the composite electrode can be adjusted. For example, after detection, when the volume doping amount of the metal 52 in the composite electrode 5' is controlled within the above range of being greater than 0 and less than or equal to 8%, and further from 0.5% to 5%, compared to electrodes doped with other amounts of the metal 52, on the basis of effectively improving the conductivity of the composite electrode to meet the electrical conductivity requirements of the back electrode of the perovskite solar cell, the stability of the metal 52 in the composite electrode 5' is improved, thereby enhancing the photoelectric performance and the stability of the photoelectric performance of the perovskite solar cell.

In some embodiments, the conductive oxide substrate contained in the composite electrode according to the foregoing embodiments includes a metal oxide. By using the metal oxide as the conductive oxide substrate, excellent chemical stability and conductivity are achieved, and moreover, some metal oxides have the light transmittance, thereby allowing the composite electrode according to this embodiment of the present application to simultaneously have the excellent chemical stability, conductivity, and light transmittance. When the composite electrode according to this embodiment of the present application is used as the back electrode of the perovskite solar cell, the photoelectric performance and the stability of the photoelectric performance of the perovskite solar cell can be further improved, and an application range of the perovskite solar cell can be broadened.

In an embodiment, when the conductive oxide substrate includes a metal oxide, a metal element contained in the metal oxide includes at least one of a Group IIIA element, a Group IVA element, a Group IB element, and a Group IIB element.

In an embodiment, when the metal element in the metal oxide includes the Group IIIA element, the Group IIIA metal element may include at least one of aluminum, gallium, indium, and thallium. For example, in an exemplary example, the metal oxide may include at least one of aluminum oxide (Al₂O₃), gallium oxide (Ga₂O₃), indium oxide (In₂O₃), and thallium oxide (Tl₂O₃).

In an embodiment, when the metal element in the metal oxide includes the Group IVA element, the Group IVA metal element may include tin. For example, in an exemplary example, the metal oxide may include, but is not limited to, tin oxide (SnO₂).

In an embodiment, when the metal element in the metal oxide includes the Group IB element, the Group IB metal element includes at least one of copper, gold, and silver. For example, in an exemplary example, the metal oxide may include at least one of copper oxide (CuO), silver oxide (Ag₂O), and gold oxide (Au₂O₃).

When the metal element in the metal oxide includes the Group IIB element, the Group IIB metal element includes at least one of zinc and cadmium. For example, in an exemplary example, the metal oxide may include at least one of zinc oxide (ZnO), cadmium oxide (CdO), etc.

Based on the types of the foregoing metal oxides, the conductive oxide substrate may include one or two or more of aluminum oxide (Al₂O₃), gallium oxide (Ga₂O₃), indium oxide (In₂O₃), thallium oxide (Tl₂O₃), tin oxide (SnO₂), copper oxide (CuO), silver oxide (Ag₂O), gold oxide (Au₂O₃), zinc oxide (ZnO), and cadmium oxide (CdO), where "two or more" includes a combination of two metals. When the metal oxide is a combination of two or more metal oxides, the conductive oxide substrate contained in the composite electrode according to the foregoing embodiments may include at least the following solutions:
In an embodiment, the conductive oxide substrate may include combinations of two metal oxides, such as aluminum oxide (Al₂O₃) and thallium oxide (Tl₂O₃); gold oxide (Au₂O₃) and zinc oxide (ZnO); and aluminum oxide (Al₂O₃) and cadmium oxide (CdO).

In an embodiment, the conductive oxide substrate may include combinations of three metal oxides, such as aluminum oxide (Al₂O₃), silver oxide (Ag₂O), and zinc oxide (ZnO); tin oxide (SnO₂), copper oxide (CuO), and silver oxide (Ag₂O); and thallium oxide (Tl₂O₃), tin oxide (SnO₂), and copper oxide (CuO).

In an embodiment, the conductive oxide substrate may include combinations of four metal oxides, such as silver oxide (Ag₂O), gold oxide (Au₂O₃), zinc oxide (ZnO), and cadmium oxide (CdO); and copper oxide (CuO), silver oxide (Ag₂O), gold oxide (Au₂O₃), and zinc oxide (ZnO).

The type of the above metal oxide containing conductive oxide substrate, as well as the doping solutions involving a single metal or a combination of two or more metals, are merely examples of the conductive oxide substrate mentioned above. When the conductive oxide substrate is composed of two or more components, the content of each conductive oxide substrate may be adjusted according to requirements for the conductivity and chemical stability. Certainly, on the basis of ensuring the stability and conductivity of the composite electrode, other types of conductive oxide substrates or combinations of two or more of other conductive oxide substrates may also be selected by further considering factors such as the light transmittance and economic cost of the composite electrode.

The type of the above conductive oxide substrate or a further combination of two types allows the conductive oxide substrate to have both excellent chemical stability and conductivity. Moreover, some metal oxidations have good light transmittance, thereby allowing the composite electrode according to this embodiment of the present application to simultaneously have the excellent chemical stability, conductivity, and light transmittance.

Based on the types of the metals and the conductive oxide substrates contained in the composite electrodes according to the foregoing embodiments, in an exemplary example, when the conductive oxide includes tin oxide, the metal includes aluminum, gallium, indium, and thallium. The composite electrode containing the tin oxide substrate and the four doped metals: aluminum, gallium, indium, and thallium simultaneously have more excellent chemical stability, conductivity, and light transmittance. The applicability of the composite electrode in the perovskite solar cell is enhanced, for example, the applicability of the composite electrode as the back electrode is enhanced, the photoelectric performance and the stability of the photoelectric performance of the perovskite solar cell can be improved, and the application range of the perovskite solar cell can be broadened.

Based on the selection and control of the types and contents of the conductive oxide substrates and the metals contained in the composite electrodes according to the foregoing embodiments, in some embodiments, the composite electrode in this embodiment of the present application includes at least one of the following (1) to (3):
(1) a thickness ranging from 60 nm to 200 nm, which may further be 80 nm to 100 nm, etc., where in an exemplary example, the thickness may be typical but not exclusively limited to values such as 60 nm, 80 nm, 100 nm, 120 nm, 140 nm, 160 nm, 180 nm, and 200 nm;
(2) a work function value ranging from 4 eV to 5.5 eV, which may further be 4.26 eV to 5.20 eV, where in an exemplary example, the thickness may be typical but not exclusively limited to values such as 4.0 eV, 4.26 eV, 4.5 eV, 4.6 eV, 4.7 eV, 4.8 eV, 4.9 eV, 5.0 eV, 5.1 eV, 5.2 eV, and 5.5 eV; and
(3) a square resistance ranging from 5 Ω to 15 Ω, which may further be 7 Ω to 11 Ω, etc., where in an exemplary example, the thickness may be typical but not exclusively limited to values such as 5 Ω, 6 Ω, 7 Ω, 8 Ω, 9 Ω, 10 Ω, 11 Ω, 12 Ω, 13 Ω, 14 Ω, and 15 Ω.

Therefore, when the composite electrode according to this embodiment of the present application has at least one of the foregoing characteristics (1) to (3), the applicability of the composite electrode according to this embodiment of the present application in the perovskite solar cell is enhanced, and particularly the applicability of the composite electrode as the back electrode is enhanced. The photoelectric performance and the stability of the photoelectric performance of the perovskite solar cell can be improved, and the application range of the perovskite solar cell can be broadened.

### Method for preparing composite electrode

In a second aspect, an embodiment of the present application provides a method for preparing a composite electrode. The method for preparing a composite electrode according to this embodiment of the present application includes the following steps:
S10: Perform film formation processing on a surface of a matrix using raw materials containing a metal and a conductive oxide to form the composite electrode.

In step S10, the raw materials containing the metal may be in the form of an elemental metal, an alloy, or certainly a precursor of the elemental metal or the alloy. Similarly, the raw materials containing the conductive oxide may also be in the form of the conductive oxide or a precursor of the conductive oxide.

For the film formation processing, a corresponding film formation method may be selected according to the type of the raw materials containing the metal and the conductive oxide. For example, in an embodiment, it may include, but is not limited to, one or a combination of two or more of film formation methods such as spin coating and annealing, evaporation, sputtering, and atomic layer deposition. In an exemplary example, when the raw materials containing the metal and the conductive oxide are in the form of the metal and the conductive oxide, one or a combination of two or more of film formation methods such as co-evaporation, sputtering, and atomic layer deposition may be used.

Certainly, the composite electrode prepared by the method for preparing a composite electrode according to this embodiment of the present application is the same as the composite electrode in the above embodiment of the present application.

Therefore, the method for preparing a composite electrode according to this embodiment of the present application can effectively achieve doping of the conductive oxide substrate with the metal, and endow the prepared composite electrode with excellent chemical and conductive properties. Moreover, the method for preparing features easy process control, ensures the quantitative production of the composite electrode, and can guarantee the performance stability of the composite electrode, including the quality.

The composite electrode according to the above embodiment of the present application and the composite electrode prepared by the method for preparing a composite electrode can be applied in a perovskite solar cell, and certainly, may also be used in other products. Based on the foregoing performance of the composite electrode according to the above embodiment of the present application, the following embodiments of the present application further provide a perovskite solar cell and a method for preparing the same.

### Perovskite solar cell

In a third aspect, an embodiment of the present application provides a perovskite solar cell (hereinafter referred to as a solar cell). In some embodiments, a structure of the solar cell according to this embodiment of the present application is as shown in FIG. 4, which may include a transparent electrode 1 and a back electrode 5 that are oppositely arranged. A first transport layer 2, a perovskite light-absorbing layer 3, and a second transport layer 4 are also arranged between the transparent electrode 1 and the back electrode 5. That is, in a direction from the transparent electrode 1 to the back electrode 5, the transparent electrode 1, the first transport layer 2, the perovskite light-absorbing layer 3, the second transport layer 4, and the back electrode 5 are sequentially stacked.

According to this embodiment of the present application, the transparent electrode 1 and the back electrode 5 contained in the solar cell are used as conductive components. One of the first transport layer 2 and the second transport layer 4 is a hole transport layer, and the other is an electron transport layer. The back electrode 5 includes the composite electrode according to the above embodiment of the present application. Stacked arrangement should be understood as a manner in which various layers of the solar cell are combined, such as laminated bonding.

Therefore, the back electrode 5 in the solar cell according to this embodiment of the present application has good chemical stability, good stability of the operational performance, and excellent electrical conductivity, thereby improving the photoelectric performance and stability of the photoelectric performance of the perovskite solar cell. Further, since the composite electrode according to the above embodiment of the present application may also achieve light transmittance, such as being translucent, the back electrode 5 may further achieve light transmittance, such as being translucent, thereby expanding application scenarios of the solar cell according to this embodiment of the present application.

Since the back electrode 5 includes the composite electrode according to the above embodiment of the present application, in some embodiments, the back electrode 5 may be of a structure as shown in FIG. 1, that is, the metal contained therein is uniformly doped in the conductive oxide matrix 51 formed by the conductive oxide substrate. In some embodiments, the back electrode 5 may also be of a structure as shown in FIG. 2, that is, the metal contained therein is gradient-doped in the conductive oxide matrix 51 formed by the conductive oxide substrate.

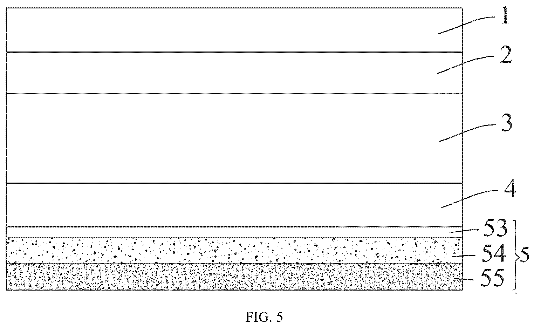

When the back electrode 5 is of a metal gradient-doped structure as shown in FIG. 2 and FIG. 3, in some embodiments, in the thickness direction of the composite electrode 5', the side (surface) of the composite electrode 5' with a low metal content is adjacent to the second transport layer 4, such as being stacked with the second transport layer 4. Specifically, when the back electrode 5 is of the structure of the composite electrode 5' according to the above embodiment of the present application as shown in FIG. 3, which specifically includes a first metal-doped layer 53, a second metal-doped layer 54, and a third metal-doped layer 55, the first metal-doped layer 53 is adjacent to the second transport layer 4, specifically being stacked with a surface of the second transport layer 4, as shown in FIG. 5. Therefore, the back electrode 5 not only has good chemical stability but also possesses superior conductivity, to more effectively collect excitons transmitted from the second transport layer 4, thereby further enhancing the photoelectric performance and the stability of the photoelectric performance of the perovskite solar cell.

Certainly, when the back electrode 5 is of the metal gradient-doped structure as shown in FIG. 2 and FIG. 3, the side with a high metal content, specifically the third metal-doped layer 55 as shown in FIG. 3 may also be adjacent to the second transport layer 4. Accordingly, on the basis of giving full play to the composite electrode according to the above embodiment of the present application, the migration of the metal into the perovskite light-absorbing layer 3 may also be reduced, thereby improving the stability of the photoelectric conversion efficiency of the perovskite light-absorbing layer 3.

The transparent electrode 1 included in the solar cell according to this embodiment of the present application may be an electrode that allows light to pass through. It should be understood that sunlight may penetrate through the transparent electrode 1 to reach the perovskite light-absorbing layer 3.

In some embodiments, the transparent electrode 1 includes a transparent conducting oxide. The transparent conducting oxide refers to a conductive component that allows light to pass through and collects charges. The transparent conducting oxide (TCO for short), also known as transparent conductive oxide-coated glass, is obtained by plating a uniform layer of transparent conductive oxide film onto a surface of flat glass through a physical or chemical plating method. Film materials primarily include oxides of In, Sn, Zn, and Cd, as well as composite multibasic oxide film materials thereof. By arranging the transparent electrode 1 as the transparent conducting oxide, the transparent conducting oxide is conductive, meanwhile, sufficient sunlight absorption by the solar cell can be ensured, and the photoelectric conversion is performed, thereby improving the photoelectric conversion efficiency of the solar cell according to this embodiment of the present application.

In an exemplary example, the transparent conducting oxide may include at least one of FTO, ITO, AZO, BZO, IZO, etc. FTO refers to a fluorine-doped tin dioxide (SnO₂) film. ITO refers to an indium tin oxide film. AZO refers to an aluminum-doped zinc oxide (ZnO) film. BZO refers to a boron-doped zinc oxide (ZnO) film. IZO refers to an indium-doped zinc oxide (ZnO) film. The transparent conducting oxide prepared by arranging the above transparent conductive film on the glass surface has good conductivity and light transmittance.

The first transport layer 2 and the second transport layer 4 included in the solar cell according to this embodiment of the present application are used to transport the photoexcitons produced by the perovskite light-absorbing layer 3 out of the perovskite light-absorbing layer 3. In an embodiment, when the first transport layer 2 is the electron transport layer, the second transport layer 4 is the hole transport layer. In this case, the solar cell according to this embodiment of the present application is a solar cell of a regular structure. In an embodiment, when the first transport layer 2 is the hole transport layer, the second transport layer 4 is the electron transport layer. In this case, the solar cell according to this embodiment of the present application is a solar cell of an inverted structure.

The hole transport layer refers to a component used to collect and transport holes. In an embodiment, a thickness of the hole transport layer may range from 0.1 nm to 30 nm. In an exemplary example, the thickness may be typical but not exclusively limited to 0.1 nm, 1 nm, 5 nm, 10 nm, 15 nm, 20 nm, 25 nm, 30 nm, etc.

The hole transport layer includes a hole transport material. The hole transport material may be an organic hole transport material or an inorganic hole transport material. In an embodiment, the hole transport material may include at least one of a material denoted as M, a derivative of the material denoted as M, a doped and modified material of the material denoted as M, and a passivated material of the material denoted as M. The M may include at least one of: poly[bis(4-phenyl)(2,4,6-trimethylphenyl)amine] (PTAA), poly-3-hexylthiophene (P3HT), triphenylamine with a triptycene core (H101), 3,4-ethylenedioxythiophene-methoxytriphenylamine (EDOT-OMeTPA), N-(4-anilinophenyl)carbazole-spirobifluorene (CzPAF-SBF), poly(3,4-ethylenedioxythiophene):poly(styrenesulfonate) (PEDOT:PSS), polythiophene, nickel oxide (NiOₓ), molybdenum oxide (MoO₃), copper iodide (CuI), and cuprous oxide (CuO).

These hole transport layer thicknesses and hole transport materials facilitate well collecting and transporting of holes generated by the photoexcitation of the perovskite light-absorbing layer 3. When the second transport layer 4 is the hole transport layer, these hole transport materials may be adjusted to be relatively matched with energy levels of the above back electrode 5, thereby facilitating hole transport and collection.

The electron transport layer refers to a component used to extract and transport electrons. A thickness of the electron transport layer may range from 10 nm to 80 nm. In an exemplary example, the thickness may be typical but not exclusively limited to 10 nm, 20 nm, 30 nm, 40 nm, 50 nm, 60 nm, 70 nm, 80 nm, etc.

In an embodiment, the electron transport material contained in the electron transport layer may include at least one of a material denoted as N, a derivative of the material denoted as N, a doped and modified material of the material denoted as N, and a passivated material of the material denoted as N. N includes at least one of methyl [6,6]-phenyl-C61-butyrate (PC61BM), methyl [6,6]-phenyl-C71-butyrate (PC71BM), fullerene C60 (C60), fullerene C70 (C70), tin dioxide (SnO₂), and zinc oxide (ZnO).

These electron transport layer thicknesses and electron transport materials facilitate well collecting and transporting of electrons generated by the photoexcitation of the perovskite light-absorbing layer 3. When the second transport layer 4 is the electron transport layer, these electron transport materials may be adjusted to be relatively matched with the energy levels of the above back electrode 5, thereby facilitating electron transport and collection.

The perovskite light-absorbing layer 3 contained in the solar cell according to this embodiment of the present application serves as a light-absorbing functional layer, including a perovskite material. The perovskite material may be a perovskite material in a current perovskite light-absorbing layer. In some embodiments, the perovskite material may include perovskite with a chemical formula ABX₃ or A₂CDX₆. A may include at least one of inorganic cations and organic cations. In an exemplary example, A may include at least one of CH₃NH₃⁺, HC(NH₂)₂⁺, Li⁺, Na⁺, K⁺, Rb⁺, and Cs⁺.

B may include at least one of inorganic cations and organic cations. In an exemplary example, B may include at least one of Pb²⁺, Sn²⁺, Be²⁺, Mg²⁺, Ca²⁺, Sr²⁺, Ba²⁺, Zn²⁺, Ge²⁺, Fe²⁺, Co²⁺, and Ni²⁺.

C may include at least one of inorganic cations and organic cations. In an exemplary example, C may include Ag⁺.

D may include at least one of inorganic cations and organic cations. In an exemplary example, D may include at least one of Bi³⁺, Sb³⁺, and In³⁺.

X may include at least one of inorganic cations and organic cations. In an exemplary example, X may include at least one of Cl⁻, Br , I⁻, and SCN⁻.

Based on the above ABX₃ or A₂CDX₆ perovskite, in an exemplary example, the perovskite may include at least one of CH₃NH₃PbI₃ (MAPbI₃), CH(NH₂)₂Pbl₃ (FAPbI₃), Cs_{0.05}(FA_{0.83}MA_{0.17})_{0.95}Pb(I_{0.83}Br_{0.17})₃ (CsFAMA), CsPbI₃, CsPbI₂Br, and CsPbIBr₂.

These perovskite materials have a relatively strong absorption capability for the sunlight and can effectively generate photoexcitons for separation and transport. The defect in the perovskite light-absorbing layer 3 formed by these perovskite materials through film formation may also be controlled to be relatively low. Therefore, these perovskite materials have relatively high light absorption energy and exhibit relatively high stability.

In an embodiment, by selecting the type of the perovskite material, a bandgap of the perovskite light-absorbing layer 3 in the foregoing embodiments may be 1.20 eV to 2.30 eV, optionally from 1.5 eV to 1.7 eV. In an exemplary example, the bandgap may be typical but not exclusively limited to 1.20 eV, 1.30 eV, 1.40 eV, 1.50 eV, 1.60 eV, 1.70 eV, 1.80 eV, 1.90 eV, 2.00 eV, 2.10 eV, 2.20 eV, 2.30 eV, etc.

By further adjusting and controlling the bandgap of the perovskite light-absorbing layer 3, the absorption capability of the perovskite light-absorbing layer 3 for the sunlight can be enhanced, thereby improving the photoelectric conversion efficiency of the solar cell. Additionally, under the influence of a passivation layer 5, the stability of the photoelectric conversion efficiency of the solar cell can be improved.

In an embodiment, the thickness of the perovskite light-absorbing layer 3 in the foregoing embodiments may range from 300 nm to 1000 nm, and further, may range from 400 nm to 700 nm. In an exemplary example, the thickness may be typical but not exclusively limited to 300 nm, 400 nm, 500 nm, 600 nm, 700 nm, 800 nm, 900 nm, 1000 nm, etc.

By further adjusting and controlling the thickness of the perovskite light-absorbing layer 3, the light absorption capability of the perovskite light-absorbing layer 3 can be further enhanced, thereby improving the photoelectric conversion efficiency of the solar cell and the stability of the photoelectric conversion efficiency. Certainly, the thickness of the perovskite light-absorbing layer 3 may also fall within other thickness ranges.

In an embodiment, in addition to containing the perovskite material, the perovskite light-absorbing layer 3 in the foregoing embodiments may also contain quantum dots. By doping the quantum dots into the perovskite light-absorbing layer 3, a spectral range of the sunlight absorbed by the perovskite light-absorbing layer 3 can be broadened, and the light absorption capability of the perovskite light-absorbing layer 3 can be improved. Additionally, the quantum dots can synergize with the perovskite material to reduce the defect in the perovskite light-absorbing layer 3, thereby improving the photoelectric conversion efficiency of the solar cell.

The quantum dots may be uniformly doped in the perovskite light-absorbing layer 3, such as forming a homogeneous mixture with the perovskite material. Certainly, the quantum dots may also be non-uniformly doped in the perovskite light-absorbing layer 3. For example, in an embodiment, a doping concentration of the quantum dots on one side of the perovskite light-absorbing layer 3 close to a sunlight incident surface is higher than that of the quantum dots on the other side. By controlling the doping concentration of the quantum dots to be higher on one side of the sunlight incident surface of the perovskite light-absorbing layer 3 than the doping concentration on the other side of the perovskite light-absorbing layer 3, the light absorption capability of the perovskite light-absorbing layer 3 can be further enhanced, and the defect of the perovskite light-absorbing layer 3 can be reduced, thereby further improving the photoelectric conversion efficiency of the solar cell according to this embodiment of the present application.

In an embodiment, the above quantum dots may be quantum dots with a bandgap smaller than that of the perovskite. For example, in an embodiment, a difference in bandgap between the quantum dots and the perovskite ranges from 0.05 eV to 0.4 eV, optionally from 0.1 eV to 0.4 eV, and may further range from 0.1 eV to 0.35 eV. In an exemplary example, the difference in bandgap may be typical but not exclusively limited to 0.05 eV, 0.1 eV, 0.15 eV, 0.2 eV, 0.25 eV, 0.3 eV, 0.35 eV, 0.4 eV, etc. In an embodiment, the bandgap of the quantum dots may range from 1.0 eV to 1.6 eV, preferably from 1.0 eV to 1.55 eV, and optionally from 1.2 eV to 1.3 eV. In an exemplary example, the bandgap of A-type quantum dots may be typical but not exclusively limited to 1 eV, 1.1 eV, 1.2 eV, 1.3 eV, 1.4 eV, 1.5 eV, 1.55 eV, 1.6 eV, etc.

Selecting the quantum dots with the bandgap can effectively enhance the absorption capability of the perovskite light-absorbing layer 3 for long-wavelength sunlight. The bandgap of the quantum dots is also referred to as an energy gap of the quantum dots, and similarly, the bandgap of perovskite is also referred to as an energy gap of the perovskite.

In an embodiment, a molar ratio of the above quantum dots to the perovskite may range from 0.01% to 2%, optionally from 0.05% to 0.5%. In an exemplary example, the doping molar content may be typical but not exclusively limited to 0.01%, 0.05%, 0.1%, 0.5%, 1%, 1.2%, 1.5%, 1.8%, 2%, etc. By the doping amount of the quantum dots in the perovskite light-absorbing layer 3, the light absorption capability of the perovskite light-absorbing layer 3 can be enhanced, and the defect of the perovskite light-absorbing layer 3 can be reduced, thereby improving the photoelectric conversion efficiency of the solar cell.

In an exemplary example, the above quantum dots may include at least one of modified or unmodified cadmium telluride (1.45 eV), modified or unmodified molybdenum selenide (MoSe₂, 1.3 eV), modified or unmodified copper indium gallium selenide (adjustable from 1.04 eV to 1.68 eV with Ga), modified or unmodified copper indium sulfide (1.5 eV), and modified or unmodified rhenium disulfide ReS₂ (1.5 eV). The modified quantum dots refer to quantum dots with surfaces containing relevant modifying groups. For example, the modifying groups may include, but are not limited to, at least one of mercaptoacetic acid groups, aminoacetic acid groups, and cyanopropionic acid groups. These quantum dots have a narrow bandgap, thereby effectively absorbing light in a non-visible region, particularly light with long wavelengths, enhancing the light absorption capability of the perovskite light-absorbing layer 3, and reducing or repairing the defects within the perovskite light-absorbing layer 3, to further improve the photoelectric conversion efficiency of the perovskite light-absorbing layer 3. Additionally, the heat transfer and accumulation from the sunlight to the perovskite light-absorbing layer 3 can be reduced, thereby enhancing the stability of the photoelectric conversion efficiency of the perovskite light-absorbing layer 3.

### Method for preparing perovskite solar cell

In a fourth aspect, an embodiment of the present application provides a method for preparing a perovskite solar cell (hereinafter referred to as a method for preparing a solar cell). In conjunction with FIG. 3, the method for preparing a solar cell according to this embodiment of the present application includes the following steps:
S20: In a direction away from a surface of a transparent electrode, sequentially form a first transport layer 2, a perovskite light-absorbing layer 3, and a second transport layer 4 which are stacked on the surface of the transparent electrode 1.
S30: Perform film formation processing on a surface of the second transport layer 4 away from the perovskite light-absorbing layer 3 to prepare a back electrode 5.

The back electrode 5 prepared in step S20 in the method for preparing a solar cell according to this embodiment of the present application is the composite electrode in the above embodiment of the present application. Therefore, the back electrode 5 contained in the solar cell prepared by the method for preparing a solar cell according to this embodiment of the present application has high stability and electrical conductivity as described above, or further has good light transmittance, such as translucency. Therefore, the prepared solar cell is endowed with the high stability of the photoelectric conversion efficiency, and meanwhile may have a broadened application range. Additionally, conditions of the method for preparing are easy to control, thereby improving the performance stability and efficiency of the prepared solar cell.

### Step S20:

To improve the bonding strength between the first transport layer 2 and the transparent electrode 1, in this embodiment, before forming the first transport layer 2 on the transparent electrode 1, first perform preprocessing on the transparent electrode 1. In an exemplary example, the preprocessing includes at least one of laser etching, plasma treatment, ultraviolet treatment, ozone treatment, etc. For example, in an exemplary example, when the transparent electrode 1 is made of a transparent conducting oxide, the preprocessing includes performing laser etching on the transparent conducting oxide, then, sequentially performing ultrasonic cleaning on the laser-etched transparent conducting oxide with solvents such as water, acetone, and isopropanol, then, blowing dry the solvents on the transparent conducting oxide under a nitrogen gun, and finally placing the transparent conducting oxide in an ultraviolet ozone machine for further cleaning.

A method for forming the first transport layer 2 and the second transport layer 4 on the transparent electrode 1 may be selected according to the types of materials used for the first transport layer 2 and the second transport layer 4. For example, when the first transport layer 2 is an electron transport layer and the second transport layer 4 is a hole transport layer, the material for the electron transport layer included in the solar cell according to the above embodiment of the present application may be subjected to film formation processing on the surface of the transparent electrode 1, and the material for the hole transport layer included in the solar cell according to the above embodiment of the present application may be subjected to film formation processing on the surface of the perovskite light-absorbing layer 3. For example, when the first transport layer 2 is the hole transport layer and the second transport layer 4 is the electron transport layer, the material for the hole transport layer included in the solar cell according to the above embodiment of the present application may be subjected to film formation processing on the surface of the transparent electrode 1, and the material for the electron transport layer included in the solar cell according to the above embodiment of the present application may be subjected to film formation processing on the surface of the perovskite light-absorbing layer 3. The film formation processing includes, but is not limited to, one of spin coating, blade coating, and slot die coating, and also includes post processing following one of the spin coating, blade coating, and slot die coating, which includes, but is not limited to: vacuum drying treatment, annealing treatment, etc.

A method for forming the perovskite light-absorbing layer 3 may be selected according to the type of the material used for the perovskite light-absorbing layer 3. In some embodiments, a corresponding film formation processing method may be selected according to the material of the perovskite light-absorbing layer 3 included in the solar cell according to the above embodiment of the present application. Precursors of these perovskite materials are subjected to film formation processing, such as preparing the perovskite precursors into a solution and then performing film formation processing on the surface of the first transport layer 2, followed by annealing treatment to form the perovskite light-absorbing layer 3.

In some embodiments, when the perovskite light-absorbing layer 3 includes the quantum dots described above, a method for forming the perovskite light-absorbing layer 3 includes the following steps:
S21: Prepare a mixed solution using the quantum dots and perovskite precursors.
S22: Perform film formation processing on the surface of the first transport layer away from the transparent electrode using the mixed solution to form a perovskite precursor film layer.
S23: Perform annealing treatment on the perovskite precursor film layer to obtain a perovskite film.

In step S21, the quantum dots may be of the types of the quantum dots mentioned above when the perovskite light-absorbing layer 3 of the solar cell according to the above embodiment of the present application contains the quantum dots. The perovskite precursors are also precursor materials for the perovskite contained in the perovskite light-absorbing layer 3 of the solar cell according to the above embodiment of the present application. A mixing ratio of the quantum dots to the perovskite precursors may be converted into a ratio of the quantum dots to the perovskite precursors according to a content ratio of the quantum dots to the perovskite in the perovskite light-absorbing layer 3 when the perovskite light-absorbing layer 3 of the solar cell according to the above embodiment of the present application contains the quantum dots.

The solvents for the mixed solution may be conventional solvents used to form the perovskite light-absorbing layer. The concentration of the mixed solution may also be adjusted according to a specific film formation method.

In step S22, the film formation processing is intended to form the film layer from the mixed solution on the matrix, such as performing the film formation processing on the surface of the first transport layer 2 to form a perovskite precursor film. In an embodiment, the film formation processing may include one of spin coating, blade coating, and slot die coating. Certainly, after forming a wet film, dry processing on the wet film is further included to remove the solvents.

In step S23, the annealing treatment is intended to transform the perovskite precursor film layer formed in step S22 into the perovskite layer. In the annealing treatment process, the quantum dots may be in-situ doped into the film layer formed by the generated perovskite.

By preparing the perovskite light-absorbing layer 3 in one step through the mixed solution formed by the quantum dots and the perovskite precursors, the defects in the perovskite light-absorbing layer 3 can be effectively reduced, and the light absorption capability, as well as the photoexcited exciton separation and transport capability of the perovskite light-absorbing layer 3 can be improved.

The back electrode 5 in step S20 may be prepared according to the method for preparing a composite electrode according to the above embodiment of the present application. To conserve space, the method for preparing the back electrode 5 in step S20 is not repeated herein. In this case, a structure of the back electrode 5 in step S20 may be the structure shown in FIG. 1 and FIG. 2, including the conductive oxide matrix 51 formed by the conductive oxide substrate and the metal 52 doped in the conductive oxide matrix 51.

### Power consuming apparatus

In a fifth aspect, an embodiment of the present application further provides a power consuming apparatus. The power consuming apparatus according to this embodiment of the present application includes a power supply unit or an energy storage unit, and certainly, may also include other auxiliary components or necessary components. The power supply unit or the energy storage unit includes the solar cell according to the above embodiment of the present application. The power supply unit or the energy storage unit may include one or more solar cells. When there are a plurality of solar cells, the plurality of solar cells may form a cell module. Since the power consuming apparatus according to this embodiment of the present application includes the solar cell according to the above embodiment of the present application, the sunlight can be effectively converted into electrical energy with relatively high efficiency, and the operational stability of the power supply unit or the energy storage unit is improved.

The power consuming apparatus may be, but is not limited to, a mobile device (e.g., a mobile phone, a tablet, and a notebook computer), an electric vehicle (e.g., a pure electric vehicle, a hybrid electric vehicle, a plug-in hybrid electric vehicle, an electric bicycle, an electric scooter, an electric golf cart, and an electric truck), an electric train, a ship and a satellite, an energy storage system, etc.

### Energy storage apparatus

In a sixth aspect, an embodiment of the present application further provides an energy storage apparatus. The energy storage apparatus includes an energy storage unit, and certainly, may also include other auxiliary components or necessary components. The energy storage unit includes the solar cell according to the above embodiment of the present application. The power supply unit or the energy storage unit may include one or more solar cells. When there are a plurality of solar cells, the plurality of solar cells may form a cell module. Since the energy storage apparatus according to this embodiment of the present application includes the solar cell according to the above embodiment of the present application, the sunlight can be effectively converted into electrical energy, and the conversion efficiency is stable for storage.

### Embodiments

Embodiments of the present application will be described hereinafter. The embodiments described below are exemplary and only used to explain the present application, and should not be construed as a limitation on the present application. If the specific technology or conditions are not specified in the embodiments, the technology or conditions described in the literature in this field or a product manual shall be followed. Used reagents or instruments without manufacturers indicated are all commercially available conventional products.

### Embodiment 1:

This embodiment provides a solar cell, including a transparent electrode, a hole transport layer, a perovskite light-absorbing layer, an electron transport layer, a passivation layer, and a back electrode which are sequentially stacked. A material of the transparent electrode is ITO conducting oxide. A material of the hole transport layer is PTAA, with a thickness of 20 nm. A material of the perovskite light-absorbing layer is CsFAMA, with a thickness of 600 nm. A material of the electron transport layer is PCBM, with a thickness of 60 nm. The back electrode includes a tin oxide base film and metal aluminum doped in the tin oxide base film, with a thickness of 80 nm. A volume ratio of metal aluminum to (metal aluminum + tin oxide) is 3%.

A method for preparing the solar cell includes the following steps:
S1: Take 20 pieces of 2.0*2.0 cm ITO conducting oxide, and remove 0.35 cm of ITO from each of two ends by laser etching to expose a glass substrate; ultrasonically clean the etched ITO conducting oxide several times with water, acetone, and isopropanol in sequence; and blow dry solvents from the ITO conducting oxide under a nitrogen gun and place the ITO conducting oxide in an ultraviolet ozone machine for further cleaning.
S2: After ultraviolet ozone treatment, spin-coat a 2 mg/mL poly[bis(4-phenyl)(2,4,6-trimethylphenyl)amine] (PTAA) organic hole transport layer on an ITO substrate at a rate of 5000 rpm/s, and then perform annealing treatment on a 100°C hot plate for 10 minutes.
S3: On the hole transport layer, perform film formation processing on a surface of the hole transport layer through a perovskite precursor solution of Cs_{0.05}(FA_{0.83}MA_{0.17})_{0.95}Pb(I_{0.83}Br_{0.17})₃ (CsFAMA) at a spin rate of 5000 rpm/s to form a perovskite precursor film; and perform annealing at 100°C for 30 minutes, carry out cooling to a room temperature, and form a CsFAMA perovskite light-absorbing layer.
S4: On a surface of the perovskite light-absorbing layer, spin-coat the electron transport layer of methyl [6,6]-phenyl-C61-butyrate (PCBM) at a spin rate of 1500 rpm/s, and then perform annealing at 100°C for 10 minutes.
S5: By using a sputtering device, sputter tin oxide at a rate of 0.1 A/s to a thickness of 20 nm, then sputter tin oxide at a rate of 1 A/s while simultaneously sputtering metal aluminum at a rate of 0.02 A/s to a total thickness of 40 nm, then sputter tin oxide at a rate of 5 A/s while simultaneously sputtering metal aluminum at a rate of 0.25 A/s to a total thickness of 80 nm, and finally form the back electrode of tin oxide doped with metal aluminum.

### Embodiment 2:

This embodiment provides a solar cell. Compared with the solar cell in Embodiment 1, by controlling a sputtering rate, the content of metal aluminum in the back electrode is adjusted, such that the ratio of aluminum to (metal aluminum + tin oxide) is 1%. All other aspects are the same as those of the solar cell in Embodiment 1.

S5: By using a sputtering device, sputter tin oxide at a rate of 0.1 A/s to a thickness of 20 nm, then sputter tin oxide at a rate of 1 A/s to a thickness of 40 nm, then sputter tin oxide at a rate of 5 A/s while simultaneously sputtering metal aluminum at a rate of 0.15 A/s to a total thickness of 80 nm, and finally form the back electrode of tin oxide doped with metal aluminum.

### Embodiment 3:

This embodiment provides a solar cell. Compared with the solar cell in Embodiment 1, by controlling a sputtering rate, the content of metal aluminum in the back electrode is adjusted, such that the ratio of aluminum to (metal aluminum + tin oxide) is 5%. All other aspects are the same as those of the solar cell in Embodiment 1.

S5: By using a sputtering device, sputter tin oxide at a rate of 0.1 A/s to a thickness of 20 nm, then sputter tin oxide at a rate of 1 A/s while simultaneously sputtering metal aluminum at a rate of 0.05A/s to a total thickness of 40 nm, then sputter tin oxide at a rate of 5 A/s while simultaneously sputtering metal aluminum at a rate of 0.35A/s to a total thickness of 80 nm, and finally form the back electrode of tin oxide doped with metal aluminum.

### Embodiment 4:

This embodiment provides a solar cell. Compared with the solar cell in Embodiment 1, the difference lies in that the content of metal aluminum in the back electrode is adjusted from 3% in Embodiment 1 to 8%, as shown in Table 1. All other aspects are the same as those of the solar cell in Embodiment 1.

### Embodiment 5:

This embodiment provides a solar cell. Compared with the solar cell in Embodiment 1, the difference lies in that the content of metal aluminum in the back electrode is adjusted from 3% in Embodiment 1 to 9%, as shown in Table 1. All other aspects are the same as those of the solar cell in Embodiment 1.

### Embodiment 6:

This embodiment provides a solar cell. Compared with the solar cell in Embodiment 1, cadmium quantum dots are doped into the perovskite light-absorbing layer, a molar amount of cadmium telluride quantum dots is 0.05% of a molar amount of perovskite CsFAMA, and all other aspects are the same as those of the solar cell in Embodiment 1.

A method for preparing the solar cell includes the following steps:
Steps S1 to S2 and S4 to S5 are the same as those in Embodiment 1. The difference lies in Step S3, which is as follows in this embodiment:
S3: Preparation of the perovskite light-absorbing layer:
S31: Prepare a mixed solution using the cadmium telluride quantum dots and the perovskite precursor Cs_{0.05}(FA_{0.83}MA_{0.17})_{0.95}Pb(I_{0.83}Br_{0.17})₃ (CsFAMA) in a ratio where the molar amount of the cadmium telluride quantum dots is 0.05% of the molar amount of the perovskite CsFAMA.
S32: Perform film formation processing on the surface of the hole transport layer using the mixed solution at a spin rate of 5000 rpm/s to form a perovskite precursor film.
S33: Anneal the perovskite precursor film at 100°C for 30 min, perform cooling to the room temperature, and form the perovskite light-absorbing layer.

### Embodiment 7:

This embodiment provides a solar cell. Compared with the solar cell in Embodiment 1, the difference lies in that metal aluminum in the back electrode is replaced with metal thallium. All other aspects are the same as those of the solar cell in Embodiment 1.

### Embodiment 8:

This embodiment provides a solar cell. Compared with the solar cell in Embodiment 1, metal aluminum in the back electrode is replaced with metal gold. All other aspects are the same as those of the solar cell in Embodiment 1.

### Embodiment 9:

This embodiment provides a solar cell. Compared with the solar cell in Embodiment 1, metal aluminum in the back electrode is replaced with metal zinc. All other aspects are the same as those of the solar cell in Embodiment 1.

### Embodiment 10:

This embodiment provides a solar cell. Compared with the solar cell in Embodiment 1, metal aluminum in the back electrode is replaced with both metal aluminum and gold. A volume ratio of aluminum to gold is 1: 1. Other aspects are the same as those of the solar cell in Embodiment 1.

### Embodiment 11:

This embodiment provides a solar cell. Compared with the solar cell in Embodiment 1, tin oxide in the back electrode is replaced with zinc oxide. Other aspects are the same as those of the solar cell in Embodiment 1.

### Embodiment 12:

This embodiment provides a solar cell. Compared with the solar cell in Embodiment 1, tin oxide in the back electrode is replaced with a composite of tin oxide and zinc oxide, and metal aluminum is replaced with a composite of metal aluminum and gold. A volume ratio of tin oxide to zinc oxide is 1 :1, and a volume ratio of aluminum to gold is 1: 1. Other aspects are the same as those of the solar cell in Embodiment 1.

### Embodiment 13:

This embodiment provides a solar cell. Compared with the solar cell in Embodiment 1, tin oxide in the back electrode is replaced with a composite of tin oxide, copper oxide, and indium oxide, and metal aluminum is replaced with a composite of metal gallium, indium, and thallium. A volume ratio of tin oxide to copper oxide to indium oxide is 1: 1: 1, and a volume ratio of gallium to indium to thallium is 1: 1: 1. Other aspects are the same as those of the solar cell in Embodiment 1.

### Embodiment 14:

This embodiment provides a solar cell. Compared with the solar cell in Embodiment 1, the difference lies in that a material of the back electrode is indium-doped tin oxide (a directly sputtered purchased target). Other aspects are the same as those of the solar cell in Embodiment 1.

### Comparative Example 1

This embodiment provides a solar cell. Compared with the solar cell in Embodiment 1, compared with the solar cell in Embodiment 1, the difference lies in the use of copper as the back electrode. Other aspects are the same as those of the solar cell in Embodiment 1.

### Comparative Example 2:

This embodiment provides a solar cell. Compared with the solar cell in Embodiment 1, compared with the solar cell in Embodiment 1, the difference lies in the use of tin oxide (i.e., without metal aluminum) as a material for the back electrode. Other aspects are the same as those of the solar cell in Embodiment 1.

Relevant performance tests and results for solar cell:
To verify the advancement of the solar cells in the embodiments of the present application, the solar cells provided in Embodiments 1 to 14 and Comparative Examples 1 to 2 are tested for relevant performance as listed in Table 1.

Photoelectric conversion efficiency (denoted as PCEᵢₙᵢₜᵢₐₗ) testing of perovskite solar cell:
Under standard simulated sunlight (AM 1.5G, 100 mW/cm²) irradiation, the cell performance is tested to obtain an I-V curve. According to the I-V curve and data fed back by a testing device, short-circuit current Jsc (in mA/cm²), open-circuit voltage Voc (in V), maximum light output current Jmpp (in mA), and maximum light output voltage Vmpp (in V) can be obtained. A fill factor FF in % of the cell is calculated using the formula FF = Jsc × Voc / (Jmpp × Vmpp). The photoelectric conversion efficiency PCE in % of the cell is calculated using the formula PCE = Jsc × Voc × FF / Pw, where Pw represents input power in mW.

Stability testing of perovskite solar cell:
A prepared cell device is placed on a 65°C hot plate in a dry room for accelerated testing, with a humidity about 5%. After 10 days, the device efficiency is retested (denoted as PCE₁₀), and a ratio of the efficiency PCE₁₀ to the initial efficiency PCEᵢₙᵢₜᵢₐₗ is calculated (PCE₁₀/Initial PCEᵢₙᵢₜᵢₐₗ). The initial efficiency is the efficiency tested according to the "Photoelectric conversion efficiency (denoted as PCEᵢₙᵢₜᵢₐₗ) testing of perovskite solar cell" in the preceding paragraph. Specific experimental results are shown in Table 2.

The perovskite solar cells obtained from the above embodiments and comparative examples are respectively tested according to the above processes, and specific values are listed in Table 1.

**Table 1**

| | Back Electrode Material | Metal/(Metal + Oxide) Volume Content/% | PCEᵢₙᵢₜᵢₐₗ (%) | PCE₁₀/PCEᵢₙᵢₜᵢₐₗ (%) |
|---|---|---|---|---|
| Embodiment 1 | Tin oxide and aluminum | 3 | 17.17 | 85.5 |
| Embodiment 2 | Tin oxide and aluminum | 1.5 | 16.65 | 80.2 |
| Embodiment 3 | Tin oxide and aluminum | 5 | 17.53 | 83.9 |
| Embodiment 4 | Tin oxide and aluminum | 8 | 17.31 | 82.11 |
| Embodiment 5 | Tin oxide and aluminum | 9 | 16.71 | 80.11 |
| Embodiment 6 (Doping quantum dots) | Tin oxide and aluminum | 3 | 17.66 | 87.3 |
| Embodiment 7 | Tin oxide and thallium | 3 | 16.93 | 80.3 |
| Embodiment 8 | Tin oxide and gold | 3 | 16.86 | 79.8 |
| Embodiment 9 | Tin oxide and zinc | 3 | 16.81 | 83.7 |
| Embodiment 10 | Tin oxide and (gold + aluminum) | 3 | 16.93 | 81.2 |
| Embodiment 11 | Zinc oxide and aluminum | 3 | 14.84 | 80.9 |
| Embodiment 12 | Tin oxide + zinc oxide + (gold + aluminum) | 3 | 15.98 | 79.6 |
| Embodiment 13 | Tin oxide + copper oxide + indium oxide and (gallium + indium + thallium) | 3 | 15.78 | 77.2 |
| Embodiment 14 | Tin oxide and indium | 3 | 15.62 | 76.5 |
| Comparative Example 1 | Copper | / | 19.17 | 53.7 |
| Comparative Example 2 | Tin oxide | / | 0.72 | 63.8 |

From Table 1, from Table 1, it can be seen that the initial efficiency of the devices provided in Embodiments 1 to 14 is significantly improved compared to Comparative Example 2, indicating that the doping of the metal into the metal oxide can effectively enhance the extraction and transport of internal carriers. Moreover, the PCE₁₀/PCEᵢₙᵢₜᵢₐₗ value in Embodiments 1 to 14 is significantly higher than that of Comparative Example 2, demonstrating that the stability of the metal-doped oxide composite electrode is also significantly improved.

Although the initial efficiency of the devices provided in Embodiments 1 to 14 is not as high as that of Comparative Example 1, the PCE₁₀/PCEᵢₙᵢₜᵢₐₗ value in Embodiments 1 to 14 is significantly higher than that of Comparative Example 1, indicating that the stability of the metal-doped oxide composite electrode is significantly higher than that of a pure metal electrode.

The cells in Embodiments 1, 3, and 6 exhibit superior overall performance, with both efficiency and stability of the prepared perovskite solar cells being good, demonstrating more excellent overall performance of the perovskite solar cells.

Further comparison of Embodiments 1 to 14 reveals that the efficiency of the devices provided in Embodiments 1 to 13 is higher than that of the device with uniformly doped indium in tin oxide in Embodiment 14, indicating that gradient doping, appropriate doping ratios, and doping of a plurality of metal compositions into a plurality of oxide compositions can significantly enhance interlayer carrier transport in the devices.

Further comparison of Embodiments 1 to 5 shows that the initial efficiency of the devices provided in Embodiments 1 to 3 gradually increases with the increase in metal doping content. As the metal doping content further increases, the initial efficiency of the devices decreases. For example, the initial efficiency of the device in Embodiment 4 is lower than that of the device in Embodiment 3, and the initial efficiency of the device in Embodiment 5 is lower than that of the device in Embodiment 4. Therefore, the volume percentage content of metal doped in the composite electrode is less than or equal to 8%, optionally in the range of 0.5% to 5%.

Finally, it should be noted that: the foregoing embodiments are merely used for describing the technical solutions of the present application, but are not intended to limit the present application. Although the present application is described in detail with reference to the foregoing embodiments, it should be appreciated by those of ordinary skill in the art that modifications may still be made to the technical solutions recorded in the foregoing embodiments, or equivalent replacements may be made to the part or all of the technical features; and these modifications or replacements will not cause the essence of corresponding technical solutions to depart from the scope of the technical solutions in the embodiments of the present application, and shall fall within the scope of the claims and the specification of the present application. In particular, as long as there is no structural conflict, the various technical features mentioned in each embodiment can be combined in any way. The present application is not limited to the particular embodiments disclosed herein, but includes all technical solutions that fall within the scope of the claims.

## Claims

1. A composite electrode, comprising a conductive oxide substrate and a metal, the metal being doped in the conductive oxide substrate.

2. The composite electrode according to claim 1, wherein the volume percentage content of the metal doped in the composite electrode is less than or equal to 8%, optionally 0.5% to 5%.

3. The composite electrode according to claim 1, wherein the metal comprises at least one metal from a Group IIIA element, a Group IB element, and a Group IIB element; the Group IIIA element comprises at least one of aluminum, gallium, indium, and thallium; the Group IB element comprises at least one of copper, gold, and silver; and the Group IIB element comprises at least one of zinc and cadmium.

4. The composite electrode according to any one of claims 1 to 3, wherein in a thickness direction of the composite electrode, the metal is in a gradient distribution within the composite electrode.

5. The composite electrode according to claim 4, wherein the composite electrode comprises a first metal-doped layer, a second metal-doped layer, and a third metal-doped layer, which are sequentially arranged in the thickness direction of the composite electrode.

6. The composite electrode according to claim 5, wherein the volume percentage content of the metal in the first metal-doped layer is 0%, the volume percentage content of the metal in the second metal-doped layer is 0.1% to 2%, and the volume percentage content of the metal in the third metal-doped layer is 2% to 8%; and/or
a thickness ratio of the first metal-doped layer to the second metal-doped layer to the third metal-doped layer is 1: (1-3): (1-5).

7. The composite electrode according to any one of claims 1 to 3, 5, and 6, wherein the conductive oxide substrate comprises a metal oxide.

8. The composite electrode according to claim 7, wherein a metal element contained in the metal oxide comprises at least one of a Group IIIA element, a Group IVA element, a Group IB element, and a Group IIB element; the Group IIIA element comprises at least one of aluminum, gallium, indium, and thallium; the Group IVA element comprises tin; the Group IB element comprises at least one of copper, gold, and silver; and the Group IIB element comprises at least one of zinc and cadmium.

9. The composite electrode according to any one of claims 1 to 3, 5, 6, and 8, wherein the metal comprises aluminum, gallium, indium, and thallium, and the conductive oxide comprises tin oxide.

10. The composite electrode according to any one of claims 1 to 3, 5, 6, and 8, wherein the composite electrode comprises at least one of the following (1) to (3):
(1) a thickness ranging from 60 nm to 200 nm, optionally 80 nm to 100 nm;
(2) a work function value ranging from 4 eV to 5.5 eV, optionally 4.26 eV to 5.20 eV; and
(3) a square resistance ranging from 5 Ω to 15 Ω, optionally 7 Ω to 11 Ω.

11. A method for preparing a composite electrode, comprising the following step:
performing film formation processing on a surface of a matrix using raw materials containing a metal and a conductive oxide to form the composite electrode.

12. The method according to claim 11, wherein a method for performing film formation on a surface of a matrix using raw materials containing a metal and a conductive oxide comprises at least one of magnetron sputtering, a co-evaporation method, an atomic layer deposition method, and an ion plating method.

13. A solar cell, comprising a transparent electrode and a back electrode which are oppositely arranged, a first transport layer, a perovskite light-absorbing layer, and a second transport layer which are sequentially stacked in a direction from the transparent electrode to the back electrode being further arranged between the transparent electrode and the back electrode; and
the back electrode comprising the composite electrode according to any one of claims 1 to 10 or the composite electrode prepared by the method according to any one of claims 10 to 12.

14. The solar cell according to claim 13, wherein in a thickness direction of the composite electrode, the metal contained in the composite electrode is in a gradient distribution within the composite electrode, and one side of the composite electrode with a low metal content is stacked towards the second transport layer.

15. The solar cell according to claim 13 or 14, wherein the second transport layer is a hole transport layer or an electron transport layer;
a hole transport material contained in the hole transport layer comprises at least one of a material denoted as M, a derivative of the material denoted as M, a doped and modified material of the material denoted as M, and a passivated material of the material denoted as M;
the M comprises at least one of: poly[bis(4-phenyl)(2,4,6-trimethylphenyl)amine], poly-3-hexylthiophene, triphenylamine with a triptycene core, 3,4-ethylenedioxythiophene-methoxytriphenylamine, N-(4-anilinophenyl)carbazole-spirobifluorene, poly(3,4-ethylenedioxythiophene):poly(styrenesulfonate), polythiophene, nickel oxide, molybdenum oxide, copper iodide, and cuprous oxide;
and/or, a thickness of the hole transport layer is 0.1 nm to 30 nm.

16. The solar cell according to claim 15, wherein an electron transport material contained in the electron transport layer comprises at least one of a material denoted as N, a derivative of the material denoted as N, a doped and modified material of the material denoted as N, and a passivated material of the material denoted as N;
the N comprises at least one of methyl [6,6]-phenyl-C61-butyrate, methyl [6,6]-phenyl-C71-butyrate, fullerene C60, fullerene C70, tin dioxide, and zinc oxide;
and/or, a thickness of the electron transport layer is 10 nm to 80 nm.

17. The solar cell according to any one of claims 13, 14, and 16, wherein quantum dots are further doped in the perovskite light-absorbing layer; and/or
a thickness of the perovskite light-absorbing layer is 400 nm to 1000 nm.

18. A method for preparing a solar cell, comprising the following steps:
in a direction away from a surface of a transparent electrode, sequentially forming a first transport layer, a perovskite light-absorbing layer, and a second transport layer which are stacked on the surface of the transparent electrode; and
performing, according to the method according to any one of claims 11 to 12, film formation processing on a surface of the second transport layer away from the perovskite light-absorbing layer, to form the composite electrode.

19. The method according to claim 18, wherein the perovskite light-absorbing layer comprises quantum dots, and a method for forming the perovskite light-absorbing layer comprises the following steps:
preparing a mixed solution using the quantum dots and perovskite precursors;
performing first film formation processing on the surface of the first transport layer away from the transparent electrode using the mixed solution to form a perovskite precursor film layer; and
performing annealing treatment on the perovskite precursor film layer to obtain the perovskite light-absorbing layer.

20. A power consuming apparatus, comprising a power supply unit or an energy storage unit, the power supply unit or the energy storage unit containing a solar cell, and the solar cell comprising the solar cell according to any one of claims 13 to 14 or the solar cell prepared by the method according to claim 18 or 19.

21. An energy storage apparatus, comprising an energy storage unit, the energy storage unit containing a solar cell, and the solar cell comprising the solar cell according to any one of claims 13 to 17 or the solar cell prepared by the method according to claim 18 or 19.
